# EUROPEAN PATENT SPECIFICATION

(11) **EP 4 693 368 B1**
(45) Date of publication and mention of the grant of the patent: **16.09.2026**
(21) Application number: 24192927.2
(22) Date of filing: 05.08.2024
(51) Int. Cl.: H10P 90/00, H10P 95/00, H10F 71/00

(54) **PROCESS FOR THE PRODUCTION OF SEMICONDUCTOR FOILS**
VERFAHREN ZUR HERSTELLUNG VON HALBLEITERFOLIEN
PROCÉDÉ DE FABRICATION DE FEUILLES SEMI-CONDUCTRICES

(43) Date of publication of application: 11.02.2026
(73) Proprietor: Umicore, 1000 Brussels (BE); IMEC, 3001 Leuven (BE)
(72) Inventor: CHO, Jinyoun, 2250 Olen (BE); Depauw, Valérie, 3001 Leuven (BE)

(56) References cited:
- VALÉRIE DEPAUW ET AL: "Wafer-scale Ge epitaxial foils grown at high growth rates and released from porous substrates for triple-junction solar cells", PROGRESS IN PHOTOVOLTAICS: RESEARCH AND APPLICATIONS, JOHN WILEY & SONS, LTD, HOBOKEN, USA, vol. 31, no. 12, 8 November 2022 (2022-11-08), pages 1315 - 1328, XP072537766, ISSN: 1062-7995, DOI: 10.1002/PIP.3634

## Description

### Technical Field

The present invention concerns a process for the production of semiconductor foils, and the use of such foils for example in solar cells or other opto-electronic or electronic device applications.

### Background

Germanium (Ge) is a semiconductor material used for many opto-electronic device applications thanks to the unique properties, such as a narrow band gap of 0.67 eV, a lattice constant of 5.66 Å, and a high hole mobility of 1900 cm²/Vs. Electron mobility is typically specified in units of cm²/(Voltage x second). Especially, thin Ge foils, also called wafers, are used for high efficiency solar cells in space applications.

In multi-junction high efficiency solar cells, Ge can be used as an active (light absorbing) material for creating a bottom junction, and further as an epitaxy template for growing III-V compound semiconductor layers thereon, the III-V compound semiconductor layers being used as an active material for creating a top junction. Typically, substrates with 100 mm or 150 mm diameter and a thickness between 130 µm and 250 µm, or substrates with 200 mm diameter and a thickness of 730 µm are used, while only up to 5 µm is needed to ensure proper infrared absorption in these structures (Lombardero et al., "Theoretical and experimental assessment of thinned germanium substrates for III-V multijunction solar cells," Progress in Photovoltaics Research and Applications, vol. 28, no. 11, p. 1097-1106, 2020). The remaining thickness only serves as a mechanical support for handling and processing. For that reason, commercial wafers of 100 mm diameter have a thickness of 175 µm, commercial wafers of 150 mm diameter have a thickness of 225 µm. This thickness can be reduced to about 80 µm in the final products via a back-grinding process.

As an alternative to back-grinding, thin semiconductor foils can be formed starting from a semiconductor substrate. Typical process steps for producing such a thin semiconductor foil are the formation of porous structures on the substrate, annealing, formation of a cap foil, and detachment of this cap foil to create the semiconductor foil.

KR 101905770 B1 describes a method for creating thin Ge foils. The primary teaching lies in the use of HBr-cleaning before the annealing process. By using HBr for cleaning, bromine (Br) forms bonds with dangling bonds in Ge, a process referred to as Br-passivation. This passivation effectively inhibits oxidation, specifically the formation of GeO or GeO₂. While GeO₂ can be evaporated, GeO remains on the surface and obstructs the formation of a Ge foil. The focus is on a cleaning method aimed at achieving homogeneous Ge foils.

US7507634 B2 outlines the procedure for producing a thin semiconductor foil. The primary focus is on the connection between porous structures and the outcomes of thin foil formation, without addressing the detachment process.

Depauw et al. ("Wafer-scale Ge epitaxial foils grown at high growth rates and released from porous substrates for triple-junction solar cells", Progress in Photovoltaics Research and Applications, https://doi.org/10.1002/pip.3634, 2022) describe the formation of a Ge wafer by a combination of porous Ge formation and annealing processes employed on a Ge substrate. Etching the Ge substrate results in the creation of porous Ge structures on the surface of the substrate. These structures serve as the foundation for producing a thin Ge foil by thermal treatment, also referred to as annealing or reorganization. The annealing leads to the formation of the thin Ge foil. Support structures or "pillars" link the foil and the "mother substrate" (sometimes also called "parent substrate"). Last step is the detachment of the Ge foil from the mother substrate.

US9236241 B2 specifies a method involving the creation of opening structures within a silicon wafer through photolithography. Multiple support regions are arranged within that opening structure. The silicon foil is detached using a roller. The uniform and completely regular distribution of the support regions ensures a consistent adhesion force between the foil and the mother substrate.

Depending on the subsequent processes, much stress can be applied to the foil and, as a result, the thin foil can be flaked, resulting in reduced quality or even a complete loss. A sufficiently high adhesion force helps to overcome this. However, a high adhesion force often comes at the cost of compromising the foil's detachability. Ultimately, the foil can even break, leading to additional losses in production. Consequently, there is still a need for an improved process for producing thin semiconductor foils.

### Summary

To overcome problems of the prior art, it is therefore an objective of the present invention to provide a method for producing a semiconductor foil that combines consistent adhesion forces to the substrate with good detachability from the substrate, to avoid or reduce breaking of such foils and resulting losses in the production process.

The present inventors surprisingly found that varying the distance between adjacent solid support structures in a first direction (x-direction, x-axis) as compared to a second, different, direction (y-direction, y-axis), i.e. by varying the mean pitch in the x as compared to the y direction, improves the stress-resistance and the detachability of the semiconductor foil.

The method establishes a direct correlation between the detachment of the produced cap foil and the orientation and density of the solid support structures. As a result, the process of detaching the cap foil from the substrate demands less force, while maintaining an overall high adhesion force and thus good stability.

The invention is set out in the appended set of claims.

Accordingly, a first aspect describes a process for the production of a semiconductor foil, comprising the steps:
- Providing a first semiconductor substrate having a top surface and bottom surface;
- Forming a plurality of open cavities at the top surface of the first semiconductor substrate;
- Annealing the first semiconductor substrate, thereby obtaining:
   a cap foil on top of said plurality of open cavities, whereby the cap foil covers the plurality of open cavities thereby forming a plurality of closed pores, and,
   a plurality of solid support structures, said solid support structures extending between the first semiconductor substrate and the obtained cap foil and being separated by the plurality of pores;
- Detaching the cap foil by detachment means, thereby breaking the plurality of solid support structures and obtaining the semiconductor foil, and a second semiconductor substrate comprising fractured support structures;
wherein
the solid support structures are arranged along two distinct directions x and y, wherein the mean pitch along the x direction is smaller than the mean pitch along the y direction; and,
characterized in that
the detaching starts from a side along the direction with a wider mean pitch between the solid support structures.

The current process describes the production of a semiconductor foil. The applied process thus works equally well for different semiconductors, for example for foils made of germanium or silicon.

The process involves creating a cap foil by the formation of a plurality of open cavities in the top surface of the first semiconductor substrate according to a selected, predetermined pattern, thereby selectively manipulating the structure of the substrate's top surface, resulting in surface regions with open cavities and others with solid structures. This is followed by annealing the substrate (i.e. heat treatment), thereby obtaining a cap foil on top of the plurality of cavities and solid structures, and transforming the plurality of open cavities into a plurality of closed pores. The obtained cap foil (i.e. the new top layer) is then selectively detached to create a semiconductor foil. The arrangement of the solid support structures and the choice of the detachment direction play an important role in this process.

The formation of the plurality of open cavities is typically achieved through methods such as dry etching, laser ablation, chemical etching or electrochemical etching.

The selected predetermined pattern for the plurality of cavities and therefore of the plurality of pores is selected to enable an adhesion force between the cap foil and the first semiconductor substrate (mother substrate) that is carefully balanced to be sufficiently strong to prevent delamination during different processes, yet weak enough to enable successful detachment of the cap foil (in a later stage of the process). The detachment phase represents a critical step in realizing the concept of a thin semiconductor foil.

The trade-off between adhesion force (preventing delamination) and detachability in typical prior art processes can be overcome by introducing a completely different geometry of the solid support structures (i.e. the "pillars"), and then detaching in a particular direction preferred for this geometry. Strategically placing cavities and solid support structures with varying pitch in the x and y direction allows for the simultaneous achievement of strong adhesion force and improved detachability.

One distinct advantage of the process of the present invention is that it establishes a direct correlation between the detachment of the cap foil and the orientation and density of the solid support structures. As a result, the process of detaching the cap foil from the substrate demands less force, while maintaining an overall high adhesion force. It's worth noting that the formation of the solid support structures, involving a non-uniform distribution in both the x and y direction, deviates from the conventional approach known from prior art. Hereby it does not really matter if the wider mean pitch is in x or y direction, as long as the mean pitch in the two directions x and y is different from each other, and detaching always starts from the direction with the wider mean pitch (= less solid support structures to break simultaneously during detachment).

In order to model the detachability with respect to the geometry of the solid support structures, varying pitches were employed.

A further aspect describes a process, wherein the mean pitch along the x direction is between 2 and 9 µm, and wherein the mean pitch along the y direction is between 10 and 500 µm. This geometry is particularly advantageous in combining strong adhesion force and improved detachability of the cap foil.

The pitch range for a pillar diameter of 500 nm - 1800 nm is preferably in a range of 2 µm to 500 µm.

Another aspect that influences the detachability of the cap foil is the pillar density (density of the solid support structures). It is noteworthy that when applying the pillar geometry as described above, the detachment can even be achieved under high pillar density conditions (1/(4 x 12 µm²). Pillar density means number of pillars in an unit area multiplied with the average pillar diameter.

The adhesion force between the cap foil and the first semiconductor substrate can be advantageously controlled and allows sufficiently strong solid support structures in case other manufacturing processes are envisaged before detaching, for example cleaning, polishing or epitaxial growth of additional layers on the top surface of the cap foil.

Depending on the specific process flow, the detachment of the cap foil can thus occur either right after the formation of the foil or at a later stage in subsequent processes.

A further aspect describes a process, wherein the directions x and y are orthogonal. In this regard, orthogonal refers to rows of solid support structures in x or y direction that intersect or lie at right angles to each other.

A further aspect describes a process, wherein the average diameter of the solid support structures after annealing is from 500 nm to 1800 nm, or from 600 nm to 1200 nm, or from 700 nm to 1100 nm, as measured by SEM. A scanning electron microscope (SEM) is a type of electron microscope that produces images of a sample by scanning the surface with a focused beam of electrons.

This design consideration ensures that the detachment process can be carried out efficiently, minimizing the risk of damaging the cap foil or the epitaxial layers grown on it in a later stage. The average diameter of the solid support structures can be easily adapted to different process needs.

Different detachment means are known for the detachment of such thin top layers. One option is the detachment by vacuum suction.

Another option is the detachment by inserting a blade between the cap foil and the first semiconductor substrate, this way setting a very local stress on the solid support structures to break them apart, "cutting" them.

A successful detachment of the cap foil from the substrate using a blade is a significant achievement. This process demonstrates the feasibility of separating the cap foil from the mother substrate and allows manufacturing and utilization of thin semiconductor foils in various applications.

A further aspect therefore describes a process, wherein the detachment means are cutting means, such as a blade, and wherein said cutting means are inserted between the cap foil and the first semiconductor substrate and moved in the x-direction, whereby a cutting edge of the cutting means is oriented parallel to the y-direction.

This way the cutting means cut the solid support structures from the direction with a wider mean pitch, thus cutting fewer of the solid support structures at the same time compared to cutting from the direction with a smaller mean pitch. Cutting this way reduces stress on the cap foil, facilitates lift-off and reduces the risk of breaking the cap foil during lift-off.

The orientation of a cutting edge of the cutting means is parallel to the y-axis. The movement is in the direction of the x-axis.

A further aspect describes a variation of the process, wherein the detachment means are cutting means, and wherein said cutting means are inserted between the cap foil and the first semiconductor substrate and moved in the x-direction, whereby a cutting edge of the cutting means is oriented at an angle of 10 to 45° to the y-direction.

This way the cutting means cut the solid support structures also from the direction with the wider mean pitch, but does not cut all of the solid support structures in a single row at the same time. The variation of the angle of the cutting means in combination with the pre-defined pattern of the solid support structures allows to finetune the cutting in a way that a minimum number of the solid support structures are cut at the same time. Again, this reduces stress on the cap foil, facilitates lift-off and reduces the risk of breaking the cap foil during lift-off.

A further aspect describes a process, wherein the cap foil has a thickness of 500 nm to 2000 nm, or 750 nm to 1750 nm, or 1000 nm to 1500 nm, as measured by SEM.

Depending on the application, the foil thickness can be advantageously adapted.

A foil with a thickness of about 1000 nm to 1500 nm is particularly suitable to be used as substrate for growing at least one epitaxial layer thereon, thereby forming a layered wafer that can be used subsequently for fabricating optoelectronic or electronic devices.

The thickness of the foil is influenced by factors such as the diameter and depth of the open cavities, as well as the diameter and spacing (mean pitch or mean distance) of the solid support structures. When the foil thickness is insufficient, cracks may propagate through the foil during mechanical detachment. To achieve most reproducible results and minimize losses in the process, a foil thickness of less than 500 nm is therefore considered insufficient. A foil thickness exceeding 2000 nm is less preferred, as this would require etching more material and significantly longer annealing times. Too thick foils are also economically less preferred.

A further aspect describes a process, wherein the thickness of the cap foil is bigger than the average diameter of the solid support structures after annealing, as measured by SEM.

When mechanical detachment is performed, cracks may develop either in the solid support structures or in the cap foil. To ensure a high yield during detachment, the cap foil is preferably stronger than the solid support structures. Therefore, it is preferred that the thickness of the cap foil is bigger than the average diameter of the solid support structures.

A further aspect describes a process further comprising a step of providing a mask for forming the plurality of open cavities at the top surface of the first semiconductor substrate. In the field of semiconductors, a mask is typically a plate with pre-defined openings, allowing to produce a pattern on the surface of a substrate.

The advantage of using a mask is that the location, shape and dimensions of the plurality of open cavities or voids, which form later the closed pores, and the remaining "walls" between the plurality of open cavities, which form later the solid support structures or "pillars", can be exactly and accurately determined. The resulting "pattern" at the top surface of the first semiconductor substrate can thus be fine-tuned to a specifically desired geometry, which directly influences the resulting adhesion force between the cap foil and the first semiconductor substrate, which are connected by the solid support structures.

A higher pillar density after the step of annealing, corresponding to less and/or smaller pores, results in a higher adhesion force and increased stability. A lower pillar density, corresponding to more and/or bigger pores, allows for easier detachment.

A further aspect describes a process, wherein the average depth of the open cavities at the top surface of the first semiconductor substrate is from 1 µm to 6 µm, or from 2 µm to 5 µm, as measured by SEM.

The depth of the open cavities plays a particular role in the process of formation of a semiconductor foil. It is advantageous for the formation of a uniform cap foil, when the depth of the cavities is 3 to 20 times bigger than the diameter of the cavities. Therefore, a further aspect describes a process, wherein the ratio between the average depth of the cavities to the average diameter of the cavities is in a range of 3:1 or more to 20:1 or less (3:1 - 20:1).

If the depth of the cavities is insufficient, a large porous area cannot be formed, resulting in an adhesion force that is too high for detachment.

If the depth of the cavities is too deep, the foil may become too thin, or multiple or inhomogeneous layers may form on the surface. This can cause significant difficulties in the detachment process, or in the quality of the foil.

A further aspect describes a process, wherein the annealing step is performed in a reducing environment, for example at 50 to 760 Torr H₂. A reducing atmosphere, such as pure hydrogen (H₂) or a gas mixture of nitrogen (N₂) and hydrogen (H₂), is thus ideally maintained at a pressure of 50 to 760 Torr.

For example, when the surface of the first semiconductor substrate gets oxidized, this can prohibit the restructuring, and negatively impact the foil formation. For that reason, deoxidation of the surface helps in the process of pore formation. A common method for achieving this is annealing in a hydrogen ambient environment.

Alternatively, the process can be carried out under argon or nitrogen.

It has been observed that nitrogen is less preferred for silicon substrates.

Alternatively annealing can be carried out under high vacuum conditions, for example at a pressure ranging from 10⁻⁸ to 10⁻¹² Torr.

Before subjecting a substrate to annealing in high vacuum, typically any surface oxide layers are removed. Thus, the process can comprise a pre-treatment with an acid solution, such as hydrofluoric acid (HF), hydrochloric acid (HCl), or hydrobromic acid (HBr) before annealing.

Alternatively, the process can comprise a pre-treatment with an alkaline solution, such as TMAH (tetramethylammonium hydroxide), KOH or NaOH before annealing.

A further aspect describes a process, further comprising a step of removing fractured support structures from the second semiconductor substrate.

The step of detaching of the cap foil causes breaking of the solid support structures. Consequently, the remaining substrate, the second semiconductor substrate, will have fractured support structures on the upper surface. This causes a certain surface roughness. Before re-using this second semiconductor substrate in a further process according to the first aspect, it is preferred to remove these structures to create a surface with less surface roughness. This allows for a better reproducibility.

For economical reasons it is preferred to select methods that minimize material losses during this removal step.

A further aspect describes a process, wherein the step of removing the fractured support structures is performed by etching, chemo-mechanical polishing or electropolishing.

Etching can comprise chemical etching, for example using a mixture of hydrogen peroxide (H₂O₂) and hydrofluoric acid (HF).

Chemical mechanical polishing (CMP), also known as chemical mechanical planarization, is a process used to smooth surfaces by combining chemical and mechanical forces.

Electropolishing, also known as electrochemical polishing, anodic polishing, or electrolytic polishing, is an electrochemical process that removes material by applying electrical bias, reducing surface roughness by leveling micro-peaks and valleys and improving the surface finish.

An alternative to the removal of fractured support structures is planarization by filling spaces between the fractured support structures. Planarization can for example be done by homoepitaxy, referring to a process wherein a crystalline film of the same material is grown on a substrate. This way existing voids are filled, and the process according to the first aspect can be restarted more efficiently.

A further aspect describes a process, wherein the second semiconductor substrate is used as first semiconductor substrate in the process according to claim 1. The second semiconductor substrate can thus be re-used. Depending on the thickness of the substrates, even multiple re-uses are possible and even industrially advantageous.

After multiple reuses, the first semiconductor substrate preferably retains sufficient rigidity to support further processes. If the substrate becomes too thin, maintaining rigidity becomes challenging. Bowing or warping can occur, leading to issues such as process non-uniformity or breaking. A preferred thickness of the first semiconductor substrate is therefore more than 100 µm for a 4 inch substrate, more than 150 µm for a 6 inch substrate, more than 300 µm for an 8 inch substrate, and more than 400 µm for a 12 inch substrate. This allows continued process reliability and performance at varying thicknesses.

A further aspect describes a process, wherein the first semiconductor substrate is a germanium substrate. Germanium has specific properties, which make it, for example, a preferred choice in wafers for solar cells, but also for other electronic or opto-electronic devices.

A further aspect describes a process, wherein the annealing step is performed at a temperature of 450 °C to 938 °C, or of 600 °C to 900 °C, or of 650 °C to 800 °C.

Restructuring of porous germanium can occur already at 250 °C (Tutashkonko et al., "Thermally induced Ostwald ripening of mesoporous Ge nanostructures", J. Appl. Phys. 113, 023517, 2013). However, such a relatively low temperature will lead to significantly longer annealing times, which is not practical in industrial processes. Therefore, a temperature of at least 450 °C is preferred in the step of annealing.

On the other hand, germanium has a melting point of 938.2 °C, which defines the upper limit in the present process for this element. For the present process to work, the substrate may not melt completely.

The upper temperature limit may change when other semiconductor materials are used. Silicon, for example, has a melting point of 1414 °C, which allows performing the process at higher temperatures than typically used for germanium.

In such processes the annealing step typically lasts between 1 and 30 minutes. Times between 5 and 20 minutes are preferred. The duration of annealing at the peak temperature may vary depending on the annealing temperature itself. If the time is too short, there is a risk of "overshoot", i.e. that the actual temperature exceeds the set temperature. If the time is too long, it prolongs the overall processing time unnecessarily.

Typically, higher temperatures allow a shorter time for annealing, while lower temperatures may increase the time for annealing.

A further aspect describes a process further comprising the steps of: bonding the semiconductor foil to a carrier substrate; epitaxial growth of at least one semiconductor layer on the upper face of the semiconductor foil, thereby forming a layered wafer; and detaching the layered wafer from the carrier substrate.

The carrier substrate provides a stable platform for the semiconductor foil. The material of the carrier substrate can be chosen from a wide variety of suitable materials and be aligned with the planned application. Furthermore, the selection of a carrier substrate depends on factors such as thermal expansion coefficient, surface quality, and compatibility with the manufacturing process.

An example for an inert carrier substrate is glass. Examples of other potential carrier substrates include sapphire, gallium arsenide (GaAs), germanium (Ge), silicon carbide (SiC), indium phosphide (InP), polymer film, or stainless steel. Additionally, when fabricating a device operating circuit on a silicon (Si) substrate, Si itself can serve as carrier substrate. Thus, the material of substrate and carrier substrate can be the same.

The use of an adhesive to bond a wafer with a carrier substrate is a common technique in substrate engineering and semiconductor manufacturing.

The wafer is bound to the carrier substrate and then subsequently used as base layer and growth template for additional layers. These can be formed of germanium, but also any other semiconductor material. Layers of different materials can be advantageously combined.

There are two possible approaches for bonding. The first approach involves detaching the cap foil and then bonding it to a carrier substrate for the subsequent processes. The second approach involves initially bonding the cap foil to a carrier substrate, then detaching. The cap foil thus remains attached to the first semiconductor substrate, and is detached from the first semiconductor substrate after bonding of a carrier substrate.

The first approach can be faster, but increases the risk of breaking the rather flexible and thin semiconductor foil during the subsequent bonding process.

The second approach involves less risk of breaking the cap foil, as it is still attached to the stabilizing first semiconductor substrate, but can be more complex in the process setup.

A further aspect describes the use of the layered wafer obtained by all previously described aspects in an optoelectronic device or in an electronic device.

A layered wafer can be used in quite different optoelectronic devices, such as solar cells, VCSELs (vertical-cavity surface-emitting lasers), LEDs, edge emitting lasers, optical communication devices or sensors. The materials required for each application, and thus for a specific type of layered wafer, can be chosen and fine-tuned according to needed properties.

Solar cells containing wafers with two or more layers made of different semiconductor materials are called multi-junction solar cells. Multi-junction solar cells comprising germanium substrates have demonstrated superior efficiency compared to their single-layer counterparts. This is due to their capacity to capture sunlight across multiple wavelengths simultaneously.

Ge can absorb light beyond 1000 nm wavelengths (up to 1600nm), additionally also UV and VIS (blue, green or red), features unachievable by silicon-based substrates (absorption up to 1000 nm). Furthermore, the wider bandgap of Ge facilitates enhanced electron movement, thereby boosting cell efficiency. This is of particular interest in space applications, as the targeted electrical power can be generated with smaller solar cells. This reduces the solar array weight and the associated launch cost, as well as the Ge metal cost and Ge depletion in general.

In addition to optoelectronic devices, layered wafers can also be used for electronic devices, such as different types of transistors (CFET, complementary field effect transistor etc.). Also here the material, or combination of materials, can be chosen and fine-tuned according to needed properties.

### Brief descriptions of the drawings

The above, as well as additional objects, features and advantages of the present disclosure, will be better understood through the following illustrative and non-limiting detailed description, with reference to the appended drawings. In the drawings like reference numerals will be used for like elements unless stated otherwise.
**Figure 1**

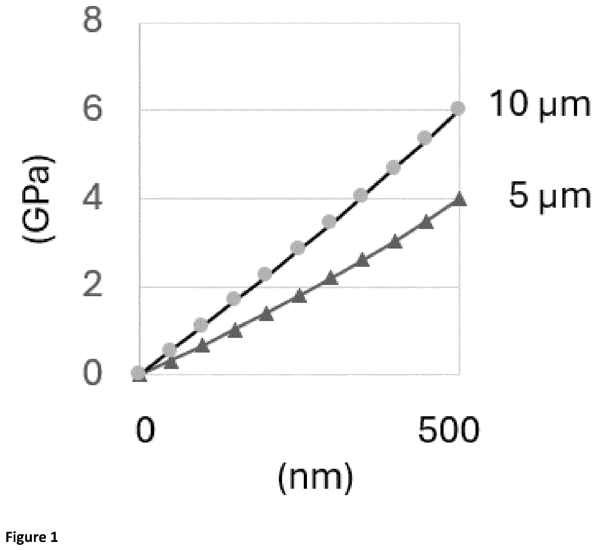

   Figure 1 shows the outcome of the simulation of the onset of the detachment process with the displacement of a cap foil with 500 nm. The maximum "stress" in the first row of solid support structures, expressed in GPa, is plotted in function of the displacement of the cap foil in the upward direction. The maximum stress is higher when the displacement is applied parallel to the solid support structures with a mean pitch of 10 µm (illustrated with dots), than when applied parallel to the solid support structures with a mean pitch of 5 µm (illustrated with triangles). This demonstrates that detachment of the cap foil from the first semiconductor substrate is easier when displacement is applied in the direction with the wider mean pitch between the solid support structures.
**Figure 2**

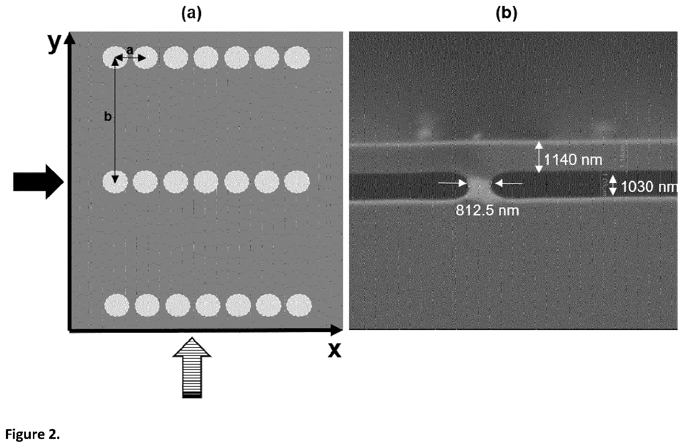

   Figure 2(a) shows an exemplary schematic top view of the arrangement (geometry) of a plurality of solid support structures. The distance labelled with "a" describes the (mean) distance or (mean) pitch between two adjacent solid support structures in X direction. The distance labelled with "b" describes the (mean) distance or (mean) pitch between two adjacent solid support structures in Y direction. Figure 2(b) shows a cross-section SEM image displaying pores and a support structure connecting cap foil (top) and first semiconductor substrate (bottom). Under the specified conditions and for this particular example the diameter of a support structure is 812.5 nm, the thickness of a germanium cap foil is 1140 nm, and the depth of the formed pore between the cap foil and the first semiconductor substrate is 1030 nm.
**Figure 3**

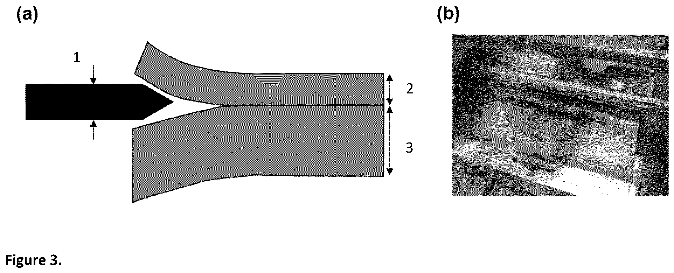

   Figure 3(a) shows a schematic cross section of an exemplary detachment method of a cap foil with a blade (1= is the thickness of the cutting means, 2 is the thickness of the cap foil, 3 = is the thickness of the first semiconductor substrate). The detachment initiates upon inserting the blade between the cap foil and the first semiconductor substrate at a lateral side thereof, ultimately leading to the detachment of the cap foil from the first semiconductor substrate.
   Figure 3(b) shows a real-life example of the detachment setup and a detached semiconductor foil.
**Figure 4**

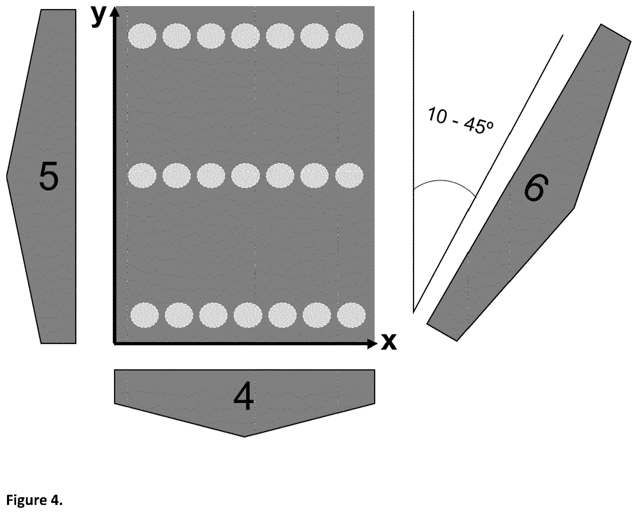

   Figure 4 shows an exemplary schematic top view of the arrangement of solid support structures and different options for the orientation of a blade. Cutting fewer of the solid support structures simultaneously is achieved by moving a blade (5), oriented parallel to the y-axis, in x-direction. Alternatively, a blade (6) can be oriented with an angle of 10 to 45 degrees to the y-axis, then also moving in x-direction (from any of the sides). In each of those cases, the force required to separate the cap foil from the first semiconductor substrate is lower than for using a blade (4) oriented parallel to the x-axis and moving in the y-direction, where more solid support structures have to be cut simultaneously. For that reason, the direction of blade (4) is less preferred for the detachment as compared to the directions of blade (5) or blade (6).

### Detailed description

Modelling was done with commercial Finite Element Modeling software MARC (https://hexagon.com/products/marc). In the modelled example, silicon was used as first semiconductor substrate, the solid support structures and the cap foil. The silicon was treated as isotropic linear elastic, with a Young's Modulus of 169 GPa and a Poisson's ratio of 0.23. A fixed displacement was applied in one edge of the cap foil, with an magnitude of 500 nm. Stress distribution was calculated in all the solid support structures. In the plot, the maximum stress for a detachment in the first row of solid support structures was reported.

In the model, the mean pitch of the solid support structures is 5 µm in x-direction and 10 µm in y-direction. For the same applied displacement, stress in the solid support structures with 5 µm pitch is lower. This means that it is more difficult to break those solid support structures. As high as possible stress for as low as possible applied displacement facilitates breaking the solid support structures. This is obtained with a wider mean pitch.

Thus, according to the simulation results, there exists a clear correlation between the detachment force and the geometry of the solid support structures. Specifically, when the "detachment front" of the cutting means encounters fewer solid support structures simultaneously, it results in easier detachment.

For the invention to work it is equally fine to have the mean distance or the mean pitch as basis. A mean distance is calculated by measuring the open spaces ("spacing") between the solid support structures, adding them up, and then dividing by the number of spaces. This method does not take into account the width of the solid support structures.

A mean pitch is calculated the same way, but instead of measuring the open spaces, the center-to-center distance between the solid support structures is used for the calculation. So it could also be referred to as "on-center spacing" or "center-to-center spacing". This method takes into account the width of the solid support structures.

According to the present invention, the detachment of the cap foil is starting from a side having a wider mean distance or mean pitch between the support structures (in other words: from a side having a lower density of solid support structures), independent of the precise calculation method used.

The solid support structures are thus arranged in two distinct directions, and the number of solid support structures subjected to force simultaneously during the detachment varies depending on the direction of the separation. This is exemplary illustrated by a solid arrow vs. dashed arrow in Figure 2. Starting from a side along a direction with lower density of solid support structures is advantageous because it enables detachment with lower force. In the example shown in Figure 2 there are (schematic) only three solid support structures to be broken simultaneously when moving a blade in the x-direction (solid arrow), while it would be seven when moving in the y-direction (dashed arrow). Consequently, detaching in the x-direction starting from a side along the y-direction is easier, causing less stress on the cap foil, while detaching in the y-direction would be harder, causing more stress on the cap foil.

To clarify, the concept of "stress" is used in two ways:
"Stress" on the cap foil should be avoided as much as possible, as it may cause cracks and breaking of the cap foil, leading to losses.
"Stress" on the solid support structures, on the other hand, facilitates breaking of the solid support structures during detachment (displacement) of the cap foil. (This is, for example, illustrated in Figure 1.)

The invention is further described in the following example.

### Example

A Ge substrate of 200 mm in diameter, with a thickness of 720 µm, a crystal orientation of (100) and a 6-degree offcut towards the (111) orientation was provided.

The Ge substrate was subjected to deep-UV lithography and dry etching, creating an array of straight columnar open cavities at the top surface of the substrate. The pattern of cavities was formed by a lithography process using a specific lithography mask. The mean pitch, i.e. the "spacing", of the solid support structures was 4 µm along the x-axis and 12 µm along the y-axis. The desired regions on the surface of the substrate were defined during the lithography process, ranging from 0.9 cm x 0.8 cm zones to exposing the entire substrate. The substrate was masked with photoresist (a know method e.g. from photolitography) and a PECVD SiOx dielectric mask. The dielectric mask was opened with CH₄F₈/O₂/Ar plasma, Ge was etched with HBr/Cl₂, and the mask removed.

The substrate with open cavities, with a diameter of 400 nm and with a depth of about 4 µm was then placed in a load-locked chemical vapor deposition reactor, where it underwent an annealing step in a reducing environment (730°C at 780 Torr H₂). This annealing process lasted 20 minutes at the peak temperature and led to the restructuring of the surface. After that, the sample was cooled down to 250°C and placed in load-lock (a separated chamber for substrates in and out). Result was the formation of a Ge cap foil of about 1 µm thickness, with a closed (top) surface and comprising a plurality of solid support structures extending between the Ge substrate and the Ge cap foil, the solid support structures being separated by the closed pores.

A 700-µm Corning SG 3.4 glass substrate was coated with Brewer Science adhesive brewerBOND-305, and an edge-bead removal (EBR) of 1 cm was applied. Then, the cap foil was bonded with the above-mentioned glass substrate. Bonding with glass was achieved according to known procedures (e.g. Prog. Photovolt. Res. Appl. 2022; 1-14; DOl: 10.1002/pip.3634).

Then, detachment using a blade was carried out in direction of the x-axis, with the blade parallel to the y-axis, by inserting the blade between the cap foil and the substrate. This means detachment started from the direction with a wider mean pitch of the solid support structures.

In this particular non-limiting example, the bonding was done prior to detachment.

Conclusion: The exemplary process involves deep-UV lithography, dry etching, annealing, and detachment of the formed cap foil (in this case with prior bonding).

The experiment successfully creates a thin cap foil with a perfectly closed surface. The detachment of the cap foil is controlled by adjusting the mean pitch along the x- and y-axis, then cutting starts from the direction with the wider mean pitch, breaking less of the solid support structures simultaneously. The example demonstrates the advantages of creating a semiconductor foil (or wafer) from a substrate with specifically chosen varying (non-uniform) mean pitches in x and y direction.

## Claims

1. Process for the production of a semiconductor foil, comprising the steps:
- Providing a first semiconductor substrate having a top surface and bottom surface;
- Forming a plurality of open cavities at the top surface of the first semiconductor substrate;
- Annealing the first semiconductor substrate, thereby obtaining:
a cap foil on top of said plurality of cavities, whereby the cap foil covers the plurality of open cavities thereby forming a plurality of closed pores, and,
a plurality of solid support structures, said solid support structures extending between the first semiconductor substrate and the obtained cap foil and being separated by the plurality of pores;
- Detaching the cap foil by detachment means, thereby breaking the plurality of solid support structures and obtaining the semiconductor foil, and a second semiconductor substrate comprising fractured support structures;
wherein
the solid support structures are arranged along two distinct directions x and y, wherein the mean pitch along the x direction is smaller than the mean pitch along the y direction; and,
**characterized in that**:
the detaching starts from a side along the direction with a wider mean pitch between the solid support structures.

2. Process according to claim 1, wherein the mean pitch along the x direction is between 2 and 9 µm, and wherein the mean pitch along the y direction is between 10 and 500 µm.

3. Process according to claim 1 or 2, wherein the average diameter of the solid support structures after annealing is from 500 nm to 1800 nm, or from 600 nm to 1200 nm, or from 700 nm to 1100 nm, as measured by SEM.

4. Process according to any one of claims 1 to 3, wherein the detachment means are cutting means, and wherein said cutting means are inserted between the cap foil and the first semiconductor substrate and moved in the x-direction, whereby a cutting edge of the cutting means is oriented parallel to the y-direction.

5. Process according to any one of claims 1 to 3, wherein the detachment means are cutting means, and wherein said cutting means are inserted between the cap foil and the first semiconductor substrate and moved in the x-direction, whereby a cutting edge of the cutting means is oriented at an angle of 10 to 45° to the y-direction.

6. Process according to any one of claims 1 to 5, wherein the cap foil has a thickness of 500 nm to 2000 nm, or 750 nm to 1750 nm, or 1000 nm to 1500 nm, as measured by SEM.

7. Process according to any one of claims 1 to 6, wherein the thickness of the cap foil is bigger than the average diameter of the solid support structures after annealing, as measured by SEM.

8. Process according to any one of claims 1 to 7, wherein the average depth of the open cavities at the top surface of the first semiconductor substrate is from 1 µm to 6 µm, or from 2 µm to 5 µm, as measured by SEM.

9. Process according to any one of claims 1 to 8, wherein the ratio between the average depth of the cavities to the average diameter of the cavities is in a range of 3:1 or more to 20:1 or less.

10. Process according to any one of claims 1 to 9, further comprising a step of removing the fractured support structures from the second substrate, preferably by etching, chemo-mechanical polishing or electropolishing.

11. Process according to claim 10, further comprising a step of using the second semiconductor substrate as first semiconductor substrate in the process according to claim 1.

12. Process according to any one of claims 1 to 11, wherein the first semiconductor substrate is a germanium substrate.

13. Process according to claim 12, wherein the annealing step is performed at a temperature of 450 °C to 938 °C, or of 600 °C to 900 °C, or of 650 °C to 800 °C.

14. Process according to any one of claims 1 to 13, further comprising the steps of:
- bonding the semiconductor foil to a carrier substrate;
- epitaxial growth of at least one semiconductor layer on the upper face of the semiconductor foil, thereby forming a layered wafer; and
- detaching the layered wafer from the carrier substrate.

15. Use of the layered wafer obtained by the process according to claim 14 in an optoelectronic device or in an electronic device.

## Patentansprüche

1. Verfahren zur Herstellung einer Halbleiterfolie, umfassend die Schritte:
- Bereitstellen eines ersten Halbleitersubstrats mit einer oberen Oberfläche und einer unteren Oberfläche;
- Bilden einer Mehrzahl von offenen Hohlräumen an der oberen Oberfläche des ersten Halbleitersubstrats;
- Tempern des ersten Halbleitersubstrats, wodurch Folgendes erhalten wird:
eine Kappenfolie auf der Mehrzahl von Hohlräumen, wobei die Kappenfolie die Mehrzahl von offenen Hohlräumen bedeckt, wodurch eine Mehrzahl von geschlossenen Poren gebildet wird, und
eine Mehrzahl von festen Trägerstrukturen, wobei sich die festen Trägerstrukturen zwischen dem ersten Halbleitersubstrat und der erhaltenen Kappenfolie erstrecken und durch die Mehrzahl von Poren getrennt sind;
- Ablösen der Kappenfolie mittels Ablösevorrichtungen, wodurch die Mehrzahl von festen Trägerstrukturen abgebrochen wird und die Halbleiterfolie erhalten wird, und ein zweites Halbleitersubstrat, das gebrochene Trägerstrukturen umfasst;
wobei
die festen Trägerstrukturen entlang zweier unterschiedlicher Richtungen x und y angeordnet sind, wobei der mittlere Abstand entlang der x-Richtung kleiner ist als der mittlere Abstand entlang der y-Richtung; und
**dadurch gekennzeichnet, dass**:
das Ablösen von einer Seite entlang der Richtung mit einem breiteren mittleren Abstand zwischen den festen Trägerstrukturen beginnt.

2. Verfahren nach Anspruch 1, wobei der mittlere Abstand entlang der x-Richtung zwischen 2 und 9 µm liegt und wobei der mittlere Abstand entlang der y-Richtung zwischen 10 und 500 µm liegt.

3. Verfahren nach Anspruch 1 oder 2, wobei der mittlere Durchmesser der festen Trägerstrukturen nach dem Tempern 500 nm bis 1800 nm oder 600 nm bis 1200 nm oder 700 nm bis 1100 nm, gemessen mittels REM, beträgt.

4. Verfahren nach einem der Ansprüche 1 bis 3, wobei die Ablösevorrichtungen Schneidvorrichtungen sind und wobei die Schneidvorrichtungen zwischen die Kappenfolie und das erste Halbleitersubstrat eingeführt und in der x-Richtung bewegt werden, wodurch eine Schneidkante der Schneidvorrichtungen parallel zu der y-Richtung ausgerichtet ist.

5. Verfahren nach einem der Ansprüche 1 bis 3, wobei die Ablösevorrichtungen Schneidvorrichtungen sind und wobei die Schneidvorrichtungen zwischen die Kappenfolie und das erste Halbleitersubstrat eingeführt und in der x-Richtung bewegt werden, wodurch eine Schneidkante der Schneidvorrichtungen in einem Winkel von 10 bis 45° zu der y-Richtung ausgerichtet ist.

6. Verfahren nach einem der Ansprüche 1 bis 5, wobei die Kappenfolie eine Dicke von 500 nm bis 2000 nm oder 750 nm bis 1750 nm oder 1000 nm bis 1500 nm, gemessen mittels REM, aufweist.

7. Verfahren nach einem der Ansprüche 1 bis 6, wobei die Dicke der Kappenfolie größer ist als der mittlere Durchmesser der festen Trägerstrukturen nach dem Tempern, gemessen mittels REM.

8. Verfahren nach einem der Ansprüche 1 bis 7, wobei die mittlere Tiefe der offenen Hohlräume an der oberen Oberfläche des ersten Halbleitersubstrats 1 µm bis 6 µm oder 2 µm bis 5 µm, gemessen mittels REM, beträgt.

9. Verfahren nach einem der Ansprüche 1 bis 8, wobei das Verhältnis zwischen der mittleren Tiefe der Hohlräume und dem mittleren Durchmesser der Hohlräume in einem Bereich von 3:1 oder mehr bis 20:1 oder weniger liegt.

10. Verfahren nach einem der Ansprüche 1 bis 9, das ferner einen Schritt des Entfernens der gebrochenen Trägerstrukturen von dem zweiten Substrat, vorzugsweise durch Ätzen, chemisch-mechanisches Polieren oder Elektropolieren, umfasst.

11. Verfahren nach Anspruch 10, ferner umfassend einen Schritt der Verwendung des zweiten Halbleitersubstrats als erstes Halbleitersubstrat in dem Verfahren nach Anspruch 1.

12. Verfahren nach einem der Ansprüche 1 bis 11, wobei das erste Halbleitersubstrat ein Germaniumsubstrat ist.

13. Verfahren nach Anspruch 12, wobei der Temperschritt bei einer Temperatur von 450 °C bis 938 °C oder von 600 °C bis 900 °C oder von 650 °C bis 800 °C durchgeführt wird.

14. Verfahren nach einem der Ansprüche 1 bis 13, ferner umfassend die Schritte:
- Bonden der Halbleiterfolie an ein Trägersubstrat;
- epitaxiales Aufwachsen mindestens einer Halbleiterschicht auf der Oberseite der Halbleiterfolie, wodurch ein geschichteter Wafer gebildet wird; und
- Ablösen des geschichteten Wafers von dem Trägersubstrat.

15. Verwendung des durch das Verfahren nach Anspruch 14 erhaltenen geschichteten Wafers in einem optoelektronischen Bauelement oder
in einem elektronischen Bauelement.

## Revendications

1. Procédé pour la production d'une feuille semi-conductrice, comprenant les étapes suivantes :
- la fourniture d'un premier substrat semi-conducteur ayant une surface supérieure et une surface inférieure ;
- la formation d'une pluralité de cavités ouvertes au niveau de la surface supérieure du premier substrat semi-conducteur ;
- le recuit du premier substrat semi-conducteur, obtenant ainsi :
une feuille de recouvrement sur le dessus de ladite pluralité de cavités, moyennant quoi la feuille de recouvrement couvre la pluralité de cavités ouvertes formant ainsi une pluralité de pores fermés, et,
une pluralité de structures de support solides, lesdites structures de support solides s'étendant entre le premier substrat semi-conducteur et la feuille de recouvrement obtenue et étant séparées par la pluralité de pores ;
- le détachement de la feuille de recouvrement par des moyens de détachement, rompant ainsi la pluralité de structures de support solides et obtenant ainsi la feuille semi-conductrice, et un deuxième substrat semi-conducteur comprenant des structures de support fracturées ;
dans lequel
les structures de support solides sont agencées le long de deux directions distinctes x et y, dans lequel le pas moyen le long de la direction x est plus petit que le pas moyen le long de la direction y ; et,
**caractérisé en ce que** :
le détachement commence d'un côté le long de la direction avec un pas moyen plus large entre les structures de support solides.

2. Procédé selon la revendication 1, dans lequel le pas moyen le long de la direction x est entre 2 et 9 µm, et dans lequel le pas moyen le long de la direction y est entre 10 et 500 µm.

3. Procédé selon la revendication 1 ou 2, dans lequel le diamètre moyen des structures de support solides après recuit est de 500 nm à 1800 nm, ou de 600 nm à 1200 nm, ou de 700 nm à 1100 nm, tel que mesuré par MEB.

4. Procédé selon l'une quelconque des revendications 1 à 3, dans lequel les moyens de détachement sont des moyens de coupe, et dans lequel lesdits moyens de coupe sont insérés entre la feuille de recouvrement et le premier substrat semi-conducteur et déplacés dans la direction x, moyennant quoi un bord de coupe des moyens de coupe est orienté parallèlement à la direction y.

5. Procédé selon l'une quelconque des revendications 1 à 3, dans lequel les moyens de détachement sont des moyens de coupe, et dans lequel lesdits moyens de coupe sont insérés entre la feuille de recouvrement et le premier substrat semi-conducteur et déplacés dans la direction x, moyennant quoi un bord de coupe des moyens de coupe est orienté à un angle de 10 à 45° par rapport à la direction y.

6. Procédé selon l'une quelconque des revendications 1 à 5, dans lequel la feuille de recouvrement a une épaisseur de 500 nm à 2000 nm, ou de 750 nm à 1750 nm, ou de 1000 nm à 1500 nm, telle que mesurée par MEB.

7. Procédé selon l'une quelconque des revendications 1 à 6, dans lequel l'épaisseur de la feuille de recouvrement est plus grande que le diamètre moyen des structures de support solides après recuit, tels que mesurés par MEB.

8. Procédé selon l'une quelconque des revendications 1 à 7, dans lequel la profondeur moyenne des cavités ouvertes au niveau de la surface supérieure du premier substrat semi-conducteur est de 1 µm à 6 µm, ou de 2 µm à 5 µm, telle que mesurée par MEB.

9. Procédé selon l'une quelconque des revendications 1 à 8, dans lequel le rapport entre la profondeur moyenne des cavités et le diamètre moyen des cavités est dans une plage de 3:1 ou plus à 20:1 ou moins.

10. Procédé selon l'une quelconque des revendications 1 à 9, comprenant en outre une étape de retrait des structures de support fracturées du deuxième substrat, de préférence par gravure, polissage mécanochimique ou électropolissage.

11. Procédé selon la revendication 10, comprenant en outre une étape consistant à utiliser le deuxième substrat semi-conducteur comme premier substrat semi-conducteur dans le procédé selon la revendication 1.

12. Procédé selon l'une quelconque des revendications 1 à 11, dans lequel le premier substrat semi-conducteur est un substrat de germanium.

13. Procédé selon la revendication 12, dans lequel l'étape de recuit est réalisée à une température de 450 °C à 938 °C, ou de 600 °C à 900 °C, ou de 650 °C à 800 °C.

14. Procédé selon l'une quelconque des revendications 1 à 13, comprenant en outre les étapes suivantes :
- la liaison de la feuille semi-conductrice à un substrat porteur ;
- la croissance épitaxiale d'au moins une couche semi-conductrice sur la face haute de la feuille semi-conductrice, formant ainsi une tranche en couches ; et
- le détachement de la tranche en couches du substrat porteur.

15. Utilisation de la tranche en couches obtenue par le procédé selon la revendication 14 dans un dispositif optoélectronique ou
dans un dispositif électronique.
